# EUROPÄISCHE PATENTSCHRIFT

(11) **EP 1 192 837 B1**
(45) Veröffentlichungstag und Bekanntmachung des Hinweises auf die Patenterteilung: **19.07.2006**
(21) Anmeldenummer: 00929555.1
(22) Anmeldetag: 26.05.2000
(51) Int. Cl.: H04R 3/04, H03G 5/16

(54) **VERFAHREN ZUR VERARBEITUNG EINES AUDIOSIGNALES**
METHOD FOR PROCESSING AN AUDIO SIGNAL
PROCEDE POUR TRAITER UN SIGNAL AUDIO

(30) Priorität: 23.06.1999 DE 19928420
(43) Veröffentlichungstag der Anmeldung: 03.04.2002
(73) Patentinhaber: Micronas GmbH, 79108 Freiburg i. Br. (DE)
(72) Erfinder: VIERTHALER, Matthias, D-79108 Freiburg (DE); WINTERER, Martin, D-79194 Gundelfingen (DE)
(74) Vertreter: Patentanwälte Westphal, Mussgnug & Partner
(86) Internationale Anmeldenummer: PCT/EP2000/004798
(87) Internationale Veröffentlichungsnummer: WO 2001/001566

(56) Entgegenhaltungen:
- WO-A-97/42789
- WO-A-99/26454
- US-A- 5 359 665
- US-A- 5 668 885
- PATENT ABSTRACTS OF JAPAN vol. 008, no. 107 (E-245), 19. Mai 1984 (1984-05-19) & JP 59 022419 A (MATSUSHITA DENKI SANGYO KK), 4. Februar 1984 (1984-02-04)

## Beschreibung

Die Erfindung betrifft ein Verfahren und eine Schaltungsanordnung zur Verarbeitung eines Audiosignals, das über einen ersten Pfad am ersten Eingang eines ersten Addierers anliegt.

Derartige Verfahren und Schaltungsvorrichtungen werden in Geräten zur akustischen Wiedergabe eingesetzt, wie z. B. Fernsehgeräte, Rundfunkempfänger oder Stereoanlagen, um den Frequenzgang der Lautsprecher zu kompensieren, die akustische Wiedergabe zu verbessern, sowie eine Übersteuerung des Gerätes bzw. der Anlage zu verhindern.

Das am meisten kritische Glied in einem Gerät zur akustischen Wiedergabe ist der Lautsprecher, dessen Schalldruck unterhalb einer baubedingten Grenzfrequenz mit etwa 40 db pro Dekade abfällt, was der Übertragungsfunktion eines Filters zweiter Ordnung entspricht. Baßreflex- und Transmissionline-Lautsprecher haben dagegen Übertragungsfunktionen, die einem Filter höherer Ordnung entsprechen. Die untere Grenzfrequenz liegt typischerweise zwischen etwa 50 Hz und 200 Hz. Je tiefer die Grenzfrequenz eines Lautsprechers ausfällt, desto teurer wird seine Herstellung. Preisgünstige Geräte wie z. B. Fernseher oder tragbare Rundfunkempfänger sind daher mit einfacheren Lautsprechern ausgerüstet, deren untere Grenzfrequenz verhältnismäßig hoch liegt. Um die akustische Wiedergabe im unteren Frequenzbereich zu verbessern, wird die Grenzfrequenz durch Vorverstärkung der tiefen Frequenzen nach unten verschoben, was jedoch zu einer Übersteuerung des Endverstärkers und der Lautsprecher führen kann. Um eine Übersteuerung und möglicherweise dadurch sogar bedingte Zerstörung der Endverstärker oder der Lautsprecher zu verhindern, wird das Ausgangssignal des Baßverstärkers derart rückgekoppelt, daß bei großem Ausgangssignal die Verstärkung der tieferen Frequenzen verringert wird. Ein derartiges Verfahren ist aus der US-PS 5,305,388 bekannt.

In der US-PS 5,359,665 ist eine Schaltungsanordnung beschrieben, in der das Audiosignal unmittelbar über einen ersten Pfad dem ersten Eingang eines Addierers zugeführt wird, während es gleichzeitig über einen zweiten Pfad über einen Tiefpaß und einen Verstärker mit variabler Verstärkung dem zweiten Eingang des Addierers zugführt wird. Der Ausgang des Verstärkers ist über einen Signalpegeldetektor auf seinen Steuereingang rückgekoppelt. Durch diese Maßnahme wird eine Übersteuerung der Endverstärker verringert.

Aus den Forschungsergebnissen der Psychoakustik ist es bekannt, daß ein Mensch die Grundtonhöhe eines Tones auch dann noch eindeutig bestimmen kann, wenn die Grundfrequenz im Spektrum überhaupt nicht vorhanden ist, sondern nur noch Harmonische der Grundfrequenz. Diesen psychoakustischen Effekt macht man sich zu Nutze, indem die harmonische der Grundfrequenz erzeugt und einem Lautsprecher zugeführt wird, dessen Grenzfrequenz oberhalb dieser Grundfrequenz liegt. Ein Hörer glaubt daher, diese tiefe Grundfrequenz zu hören, obwohl sie der Lautsprecher überhaupt nicht abstrahlt.

Aus der US-PS 5,668,885 ist eine Schaltungsanordnung bekannt, die einem Lautsprecher mit verhältnismässig hoher unterer Grenzfrequenz dadurch tiefere Frequenzen als seine Grenzfrequenz "entlockt", daß Harmonische der tieferen Frequenzen erzeugt werden. Das Audiosignal liegt über einen ersten Pfad am ersten Eingang eines Addierers. In einem zweiten Pfad wird das Audiosignal tiefpaßgefiltert, gleichgerichtet, nochmals tiefpaßgefiltert und anschließend verstärkt dem zweiten Eingang des Addierers zugeführt.

In der US-PS 4,150,253 sind ebenfalls ein Verfahren und eine Schaltungsanordnung beschrieben, bei denen ein Audiosignal auf zwei Signalpfade aufgeteilt wird. Im ersten Pfad durchläuft das Audiosignal einen Hochpaß, um die Phase in Abhängigkeit von der Frequenz zu verschieben. Die Signale am Ausgang des Hochpasses, deren Pegel einen vorgegebenen Wert überschreitet, werden dem Eingang eines Generators zur Erzeugung der Harmonischen der Grundfrequenz zugeführt. Der Pegel der Signale am Ausgang des Generators wird auf einen Wert gedämpft, der unterhalb des Pegels des ursprünglichen Audiosignales liegt. Dieses gedämpfte Signal und das ursprüngliche Audiosignal werden miteinander addiert.

Aus der US-PS 4,700,390 ist ein sogenannter Synthesizer bekannt, bei dem sowohl für die unteren als auch für die höheren Frequenzen die Harmonischen erzeugt werden und zum ursprünglichen Audiosignal addiert werden, um eine bessere Wiedergabe sowohl im tiefen als auch im hohen Frequenzbereich zu erzielen.

In der US-PS 5,771,296 ist ebenfalls eine Schaltungsanordnung bekannt, bei der das Audiosignal über einen ersten Pfad unmittelbar einem Addierer zugeführt wird, während in einem zweiten Pfad die Harmonischen der unteren Frequenzen erzeugt werden und im Addierer zum ursprünglichen Signal addiert werden, um einem Hörer gewissermaßen vorzugaukeln, daß ein Lautsprecher tiefere Frequenzen abstrahlt, als es tatsächlich der Fall ist.

Schließlich ist in der US-PS 4,739,514 eine weitere Schaltungsanordnung zur Verbesserung der akustischen Wiedergabe tiefer Frequenzen bekannt. Auch bei dieser Schaltungsanordnung liegt das Audiosignal über einen ersten Pfad am ersten Eingang eines Addierers, während es über einen zweiten Pfad, in welchem ein Verstärker mit variabler Verstärkung und ein Bandpaß in Reihe liegen, dem zweiten Eingang des Addierers zugeführt wird. Ein Signalpegeldetektor, an dessen Eingang das Audiosignal liegt, steuert die Verstärkung des Verstärkers.

Alle angeführten bekannten Verfahren und Schaltungsanordnungen haben den Nachteil, daß sie wegen der Rückkopplung verhältnismässig langsam auf steigende Amplituden reagieren und deshalb trotz der Rückkopplung zu Übersteuerung neigen.

Es ist daher Aufgabe der Erfindung, ein Verfahren gemäß Oberbegriff des Anspruchs 1 und eine Schaltungsanordnung gemäß Oberbegriff des Anspruchs 9 so zu gestalten, daß der Frequenzgang eines Lautsprechers kompensiert, seine akustische Wiedergabe verbessert sowie eine Übersteuerung des gesamten Wiedergabesystems insbesondere im Bereich der tiefen Frequenzen verhindert wird.

Die Erfindung löst diese Aufgabe verfahrensmässig durch die Merkmale des Anspruchs 1.

Die Erfindung löst diese Aufgabe vorrichtungsmässig durch die Merkmale des Anspruchs 9.

Die Erfindung wird nun anhand der in den Figuren der Zeichnung abgebildeten erfindungsgemäßen Ausführungsbeispiele beschrieben und erläutert.

In der Zeichnung zeigen:
- Fig. 1: ein erstes Ausführungsbeispiel der Erfindung,
- Fig. 2: ein zweites Ausführungsbeispiel der Erfindung,
- Fig. 3: ein drittes Ausführungsbeispiel der Erfindung und
- Fig. 4: ein viertes Ausführungsbeispiel der Erfindung.

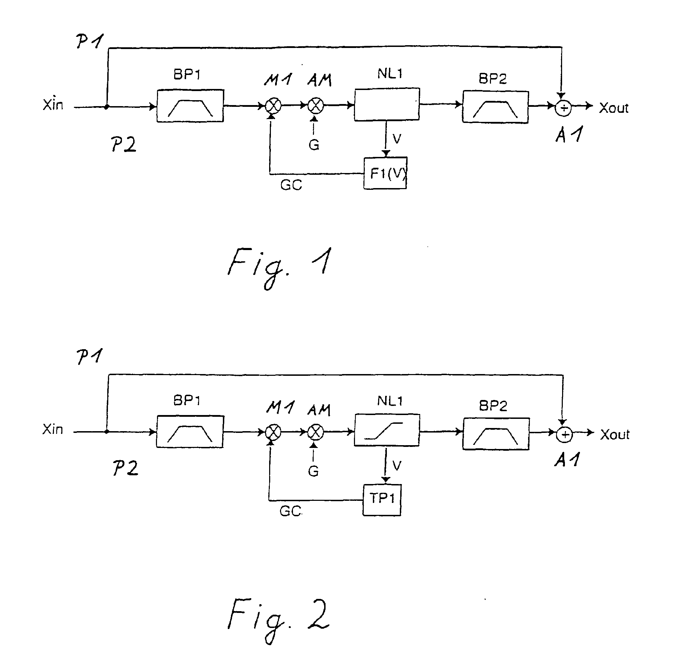

Anhand des in Fig. 1 gezeigten ersten Ausführungsbeispieles der erfindungsgemäßen Schaltungsanordnung wird das erfindungsgemäße Verfahren beschrieben und erläutert.

In der Fig. 1 wird ein Audiosignal Xin über einen ersten Pfad P1 dem ersten Eingang eines ersten Addierers A1 und über einen zweiten Pfad P2, der als Reihenschaltung aus einem ersten Bandpaß BP1, einem ersten Multiplizierer M1, einem Verstärker AM mit variabler Verstärkung, einem ersten nichtlinearen Schaltkreis NL1 sowie einem zweiten Bandpaß BP2 aufgebaut ist, dem zweiten Eingang des Addierers A1 zugeführt, an dessen Ausgang das Ausgangsaudiosignal Xout abnehmbar ist. Ein Steuerausgang des ersten nichtlinearen Schaltkreises NL1 ist mit dem Eingang eines Funktionsgenerators F1 verbunden, dessen Ausgang mit dem ersten Multiplizierer M1 verbunden ist. Am Steuereingang des Verstärkers AM liegt eine Steuergröße G.

Das Audiosignal Xin wird durch das erste Bandpaßfilter BP1 bandbegrenzt. Anschließend wird das Audiosignal mit einem variablen Korrekturfaktor GC im Multiplizierer M1 multipliziert. Das Produkt am Ausgang des Multiplizierers M1 wird im Verstärker AM mit dem Verstärkungsfaktor G verstärkt. Der nichtlineare Schaltkreis NL1 begrenzt die Amplitude des vom Verstärker AM gelieferten Audiosignales auf einen vorgebbaren Wert. Das Ausgangssignal des nichtlinearen Schaltkreises NL1 wird mittels des Bandpaßfilters BP2 bandbegrenzt. Der nichtlineare Schaltkreis NL1 erzeugt eine Kontrollvariable V, aus der der Funktionsgenerator F1 den Korrekturfaktor GC erzeugt. Dieser Korrekturfaktor GC wird vom Funktionsgenerator F1 in Abhängigkeit von der Kontrollvariablen V derart verändert, daß er bei Übersteuerung verringert wird. Liegt dagegen der Pegel des Audiosignals innerhalb der zugelassenen Grenzen, so wird der Korrekturfaktor GC vom Funktionsgenerator F1 vergrößert, höchstens jedoch bis zum Wert 1.

Es wird nun das in der Fig. 2 abgebildete zweite Ausführungsbeispiel der Erfindung beschrieben und zusammen mit dem ersten Ausführungsbeispiel aus der Fig. 1 erläutert.

Beim zweiten Ausführungsbeispiel in der Fig. 2 ist der Funktionsgenerator F1 als Tiefpaß TP1 und der erste nichtlineare Schaltkreis NL1 als Begrenzer realisiert, der die Signalamplitude oberhalb eines vorgebbaren Schwellwerts abschneidet.

Wenn die Signalamplitude den vorgegebenen Schwellwert überschreitet, gibt der nichtlineare Schaltkreis NL1 die Steuervariable V mit dem negativen Wert V1 an den Tiefpaß TP1 ab, während sie bei einer Signalamplitude, die unterhalb des vorgegebenen Schwellwertes liegt, eine Kontrollvariable V mit einem positiven Wert V2 erzeugt. Durch Filterung der Kontrollvariablen V mittels des Tiefpasses TP1 wird der Korrekturfaktor GC für den Multiplizierer M1 erzeugt.

Durch die nichtlineare Operation im nichtlinearen Schaltkreis NL1, welcher die Amplituden des Audiosignales auf einen vorgebbaren Schwellwert begrenzt, werden Audiosignale mit den unteren Frequenzen erzeugt, die auch Oberwellen des Baßsignales genannt werden. Die Form dieser Oberwellen wird durch die Wahl der nichtlinearen Operation im nichtlinearen Schaltkreis NL1 und die Dimensionierung des Bandpaßfilters BP2 bestimmt. Durch eine günstige Form dieser Oberwellen, die z. B. durch Berechnung oder durch Versuch ermittelt werden kann, erscheint dem Hörer der Beginn eines Audiosignales mit tiefen Freqzenzen, z. B. der Anschlag einer Trommel, deutlicher und klarer. Durch Wahl der Funktion des Funktionsgenerators F1 wird die Zeit bestimmt, die vergeht, bis nach dem Einsatz eines starken tieffrequenten Tones der Korrekturfaktor GC so stark verringert ist, daß durch den nichtlinearen Schaltkreis NL1 keine Oberwellen mehr erzeugt werden. Die Größe dieser Zeitspanne, die als Zeitkonstante zu betrachten ist, wird durch die Dimensionierung des Tiefpasses TP1 und die Wahl der beiden Kontrollvariablen V1 und V2 bestimmt.

Durch die oben beschriebenen erfinderischen Maßnahmen werden folgende Wirkungen erzielt:
Bei kleiner Signalamplitude arbeitet der Verstärker mit voller Verstärkung und kompensiert so teilweise die Frequenzcharakteristik eines Lautsprechers. Ist die Signalamplitude dagegen groß, so kann die Frequenzcharakteristik des Lautsprechers nur leicht kompensiert werden, weil er sonst übersteuert würde. Bei Einsetzen eines Baßsignales wird dieses Baßsignal mit Oberwellen angereichert, so daß ein Hörer trotz eines fehlenden Baßvolumens beim Lautsprecher das Empfinden hat, die Baßfrequenzen klar und deutlich zu hören.

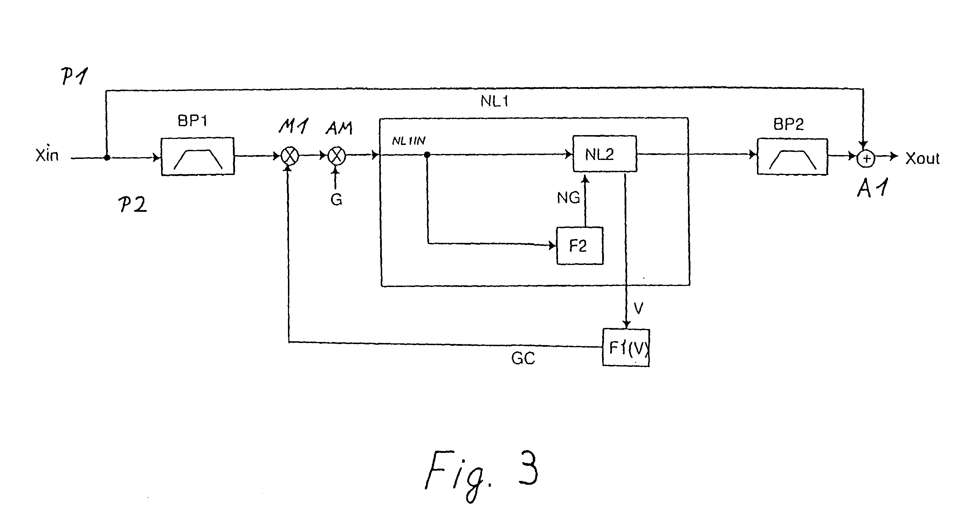

Es wird nun das in der Fig. 3 abgebildete dritte Ausführungsbeispiel der Erfindung beschrieben und erläutert.

Beim dritten Ausführungsbeispiel in der Fig. 3 ist der nichtlineare Schaltkreis NL1 ausführlich dargestellt. Der nichtlineare Schaltkries NL1 ist aus einem nichtlinearen Schaltkreis NL2 und einem Funktionsgenerator F2 aufgebaut. Das Eingangssignal des nichtlinearen Schaltkreises NL1 - das ist das Ausgangssignal des Verstärkers AM - wird dem Eingang des nichtlinearen Schaltkreises NL2 und dem Eingang des Funktionsgenerators F2 zugeführt, dessen Ausgang mit dem Steuereingang des nichtlinearen Schaltkreises NL2 verbunden ist. Der Signalausgang des nichtlinearen Schaltkreises NL2 ist mit dem Eingang des Bandpasses BP2 verbunden, während der Steuerausgang des nichtlinearen Schaltkreises NL2 mit dem Funktionsgenerator F1 oder mit dem Tiefpaß TP1 verbunden ist.

Der nichtlineare Schaltkreis NL2 erzeugt kontinuierlich Oberwellen der tieffrequenten Anteile des Audiosignales, die vom Funktionsgenerator F2 mit dem variablen Faktor NG gewichtet werden, der eine Funktion des Einganssignales ist. Je nach Wahl der Funktion des Funktionsgenerators F2 lassen sich vielfältige akustische Effekte erzeugen.

Der Funktionsgenerator F2 kann beispielsweise so gestaltet sein, daß im nichtlinearen Schaltkreis NL2 verstärkt Oberwellen erzeugt werden, sobald die Signalamplitude begrenzt werden muß, um einer Übersteuerung gegenzusteuern. Durch diese Maßnahme wird die Signalenergie auf die höherfrequenten Oberwellen verteilt, die ein Lautsprecher oder ein Lautsprechersystem besser wiedergeben kann. Obwohl nun die Energie der tieferfrequenten Signalanteile verringert wird, entsteht für den Hörer trozdem der Eindruck eines vollen Baßklanges infolge der bereits erwähnten Psychoakustischen Effekte.

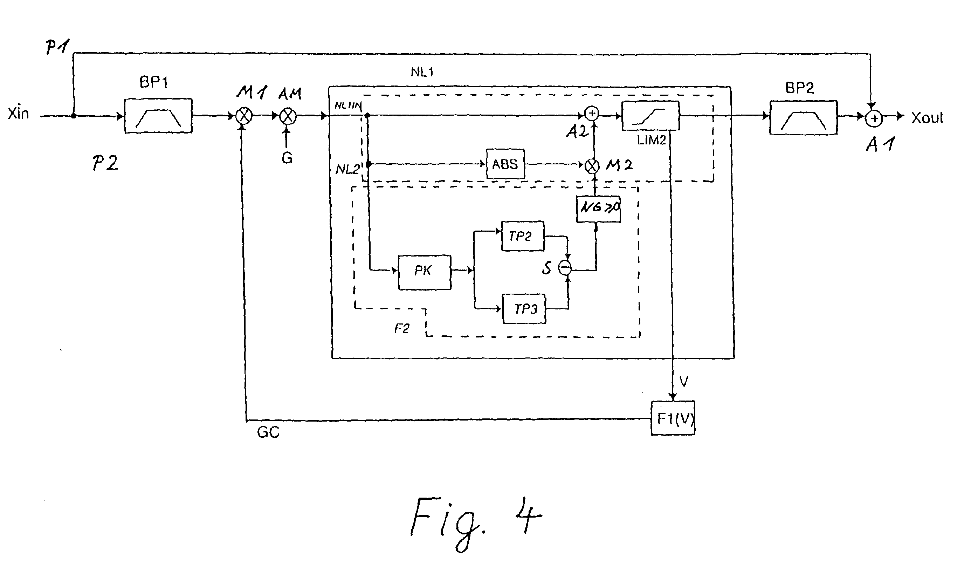

Es wird nun das in der Fig. 4 gezeigte vierte Ausführungsbeispiel der Erfindung beschrieben und erläutert.

In der Fig. 4 ist ein beispielhafter Aufbau des nichtlinearen Schaltkreises NL2 und ein beispielhafter Aufbau des Funktionsgenerators F2 im einzelnen gezeigt.

Das Eingangssignal des nichtlinearen Schaltkreises NL1, das Ausgangssignal des Verstärkers AM, liegt am ersten Eingang eines Addierers A2, am Eingang eines Absolutwertbildners ABS sowie am Eingang eines Spitzenwertdetektors PK, dessen Ausgang mit dem Eingang eines Tiefpasses TP2 und eines Tiefpasses TP3 verbunden ist. Der Ausgang des Tiefpasses TP2 ist mit dem ersten Eingang und der Ausgang des Tiefpasses TP3 mit dem zweiten Eingang eines Subtrahierers S verbunden, dessen Ausgang über einen Begrenzer LIM1 mit dem ersten Eingang eines Multiplizierers M2 verbunden ist. Der Ausgang des Absolutwertbildners ABS ist mit dem zweiten Eingang des Multiplizierers M2 verbunden, dessen Ausgang mit dem zweiten Eingang des Addierers A2 verbunden ist. Der Ausgang des Addierers A2 ist mit dem Eingang eines Begrenzers LIM 2 verbunden, dessen Steuerausgang die Kontrollvariable V an den Funktionsgenerator F1 oder den Tiefpass TP1 abgibt und dessen Ausgang mit dem Eingang des Bandpasses BP2 verbunden ist, an dessen Ausgang das Ausgangssignal für einen Lautsprecher oder ein Lautsprechersystem abnehmbar ist.

Der Spitzenwertdetektor PK bestimmt den Betrag der während eines vorgebbaren Zeitraums T vorkommenden maximalen Amplitude. Das Ausgangssignal des Spitzenwertdetektors PK wird durch die beiden Tiefpässe TP2 und TP3 zeitlich gemittelt. Die Zeitkonstante des Tiefpasses TP3 ist kleiner gewählt als die des Tiefpasses TP2, d. h. daß die Eckfrequenz des Tiefpasses TP3 mit der kleineren Zeitkonstanten höher ist als die des Tiefpasses TP2 mit der größeren Zeitkonstanten. Wegen der kleineren Zeitkonstanten folgt das Ausgangssignal des Tiefpasses TP3 einer Änderung des Eingangssignals schneller als das Ausgangssignal des Tiefpasses TP2. Der Absolutwertbildner ABS bildet den Absolutwert des Eingangssignales, der im Multiplizierer M2 mit dem vom Subtrahierer S erzeugten Faktor NG gewichtet wird, dessen Wert vom Begrenzer LIM1 nach oben auf 1 und nach unten auf 0 begrenzt wird. Der gewichtete Absolutwert des Eingangssignales wird im Addierer A2 zum Eingangssignal addiert, und die so gebildete Summe wird mittels des Begrenzers LIM2 auf eine vorgebbare Amplitude begrenzt, um Übersteuerung zu verhindern.

Wenn nun z. B. die Amplitude des Eingangssignales sprunghaft ansteigt, so wird der Pegel am Ausgang des Tiefpasses TP3 wegen der kleineren Zeitkonstanten schneller ansteigen als am Ausgang des Tiefpasses TP2. Dadurch nimmt der Faktor NG, der als Steuervariable zu sehen ist, einen positiven Wert für ansteigende Amplituden im Eingangssignal an. Je stärker der Anstieg der Amplituden des Eingangssignales ausfällt, desto mehr Oberwellen werden erzeugt und dem Eingangssignal beigemischt. Dagegen wird bei fallender Amplitude der Faktor NG negativ, weil nun der Pegel am Ausgang des Tiefpasses TP3 wegen der kleineren Zeitkonstanten kleiner wird als der Pegel am Ausgang des Tiefpasses TP2. Weil der Faktor NG nach unten hin zu Null begrenzt ist, werden bei fallenden Amplituden dem Audiosignal keine Oberwellen mehr beigemischt.

Ein wesentlicher Vorteil der Erfindung liegt darin, daß die nichtlineare Operation des nichtlinearen Schaltkreises NL1 und die Funktion des Funktionsgenerators F1 die Form der Oberwellen sowie den Zeitpunkt ihrer Erzeugung bestimmen. Durch geschickte Wahl der nichtlinearen Operation des nichtlinearen Schaltkreises und der Funktion des Funktionsgenerators läßt sich die Erfindung leicht an Lautsprecher unterschiedlicher Charakteristik anpassen, so daß stets eine optimale Kompensation des Frequenzganges eines Lautsprechers erzielt wird. Weil die Amplitude des Audiosignales durch den nichtlinearen Schaltkreis NL1 auf einen vorgebbaren Wert beschränkt wird, reagiert die erfindungsgemäße Schaltungsanordnung wesentlich schneller als der Stand der Technik auf steigende Amplituden des Audiosignales.

Die Erfindung ist insbesondere für akustische Wiedergabegeräte, z. B. Fernsehgeräte, tragbare Rundfunkempfänger, geeignet, die mit Lautsprechern ausgerüstet sind, die im Baßbereich nur schwach ausgelegt sind, denn die Erfindung verhindert eine Übersteuerung des gesamten Wiedergabesystems und bietet gleichzeitig dem Zuhörer die Illusion klangvoller Bässe, obwohl die Lautsprecher diese tiefen Baßfrequenzen überhaupt nicht abstrahlen.

### Bezugszeichenliste

- P1: erster Pfad
- P2: zweiter Pfad
- BP1: erster Bandpaß
- BP2: zweiter Bandpaß
- M1: erster Multiplizierer
- M2: zweiter Multiplizierer
- AM: Verstärker
- NL1: erster nichtlinearer Schaltkreis
- NL2: zweiter nichtlinearer Schalktreis
- F1: erster Funktionsgenerator
- F2: zweiter Funktionsgenerator
- G: Verstärkungsfaktor
- GC: Korrekturfaktor
- NG: Faktor
- V1, V2: Steuervariable
- ABS: Absolutwertbildner
- PK: Spitzenwertdetektor
- TP1: Tiefpaß
- TP2: Tiefpaß
- TP3: Tiefpaß
- S: Subtrahierer
- LIM1: Begrenzer
- LIM2: Begrenzer
- Xin: Audiosignal
- Xout: Ausgangssignal

## Patentansprüche

1. Verfahren zur Verarbeitung eines Audiosignales (Xin), das über einen ersten Pfad (P1) dem ersten Eingang eines ersten Addierers (A1) zugeführt wird,
**dadurch gekennzeichnet,**
**daß** das Audiosignal (Xin) in einem zweiten Pfad (P2) mittels eines ersten Bandpasses (BP1) bandbegrenzt wird, daß das bandbegrenzte Audiosignal am Ausgang des ersten Bandpasses (BP1) mit einem Korrekturfaktor (GC) multipliziert, mit einem Verstärkungsfaktor G verstärkt und anschließend seine Amplitude mittels eines ersten nichtlinearen Schaltkreises (NL1) auf einen vorgebbaren Höchstwert begrenzt wird, daß der Korrekturfaktor GC bei Überschreiten des vorgebbaren Höchstwertes verkleinert, ansonsten dagegen konstant bleibt oder erhöht wird, daß das Audiosignal am Ausgang des ersten nichtlinearen Schaltkreises (NL1) mittels eines zweiten Bandpasses (BP2) bandbegrenzt wird und daß das bandbegrenzte Audiosignal am Ausgang des zweiten Bandpasses (BP2) im Addierer (AD) zum Audiosignal des ersten Pfades (P1) addiert wird.

2. Verfahren nach Anspruch 1,
**dadurch gekennzeichnet,**
**daß** der Korrekturfaktor GC eine Funktion F1 einer Kontrollvariablen V ist, die der erste nichtlineare Schaltkreis (NL1) erzeugt.

3. Verfahren nach Anspruch 2,
**dadurch gekennzeichnet,**
**daß** der Korrekturfaktor (GC) einen ersten Wert (V1) annimmt, wenn die Amplitude unter dem vorgebbaren Schwellwert liegt und einen zweiten Wert (V2) annimmt, wenn die Amplitude größer als der vorgebbare Schwellwert ist.

4. Verfahren nach Anspruch 2 oder 3,
**dadurch gekennzeichnet,**
**daß** die Funktion F1 mittels eines ersten Tiefpasses (TP1) realisiert ist.

5. Verfahren nach einem der Ansprüche 1 bis 4,
**dadurch gekennzeichnet,**
**daß** der erste nichtlineare Schaltkreis (NL1) Oberwellen der tieffrequenten Signalanteile erzeugt und mit einem variablen Faktor NG gewichtet.

6. Verfahren nach Anspruch 5,
**dadurch gekennzeichnet,**
**daß** der variable Faktor NG eine Funktion F2 des Eingangssignales des ersten nichtlinearen Schaltkreises (NL1) ist.

7. Verfahren nach Anspruch 6,
**dadurch gekennzeichnet,**
**daß** der erste nichtlineare Schaltkreis (NL1) zu Beginn eines tieffrequenten Signales verstärkt Oberwellen erzeugt.

8. Verfahren nach Anspruch 7,
**dadurch gekennzeichnet,**
**daß** im ersten nichtlinearen Schaltkreis (NL1) gemäß der Funktion F2 das Eingangssignal des ersten nichtlinearen Schaltkreises (NL1) von einem Spitzenwertdetektor (PK) detektiert wird, dessen Ausgangssignal in einem zweiten und einem dritten Tiefpass (TP2, TP3) mit unterschiedlichen Zeitkonstanten tiefpaßgefiltert wird und daß das Differenzsignal der beiden tiefpaßgefilterten Signale den variablen Faktor NG darstellt, daß der Absolutwert des Eingangssignales des ersten nichtlinearen Schaltkreises (NL1) mit diesem Faktor NG gewichtet und zum Eingangssignal des ersten nichtlinearen Schaltkreises (NL1) zu einem Summenwert addiert wird, dessen Amplitude auf einen vorgebbaren Wert begrenzt wird.

9. Schaltungsanordnung zur Verarbeitung eines Audiosignales (Xin), das über einen ersten Pfad (P1) dem ersten Eingang eines ersten Addierers (A1) zugeführt wird, an dessen Ausgang das Ausgangssignal (Xout) abnehmbar ist,
**dadurch gekennzeichnet,**
**daß** das Audiosignal (Xin) über einen zweiten Pfad (P2), der als Reihenschaltung aus einem ersten Bandpaß (BP1), einem ersten Multiplizierer (M1), der das bandbegrenzte Audiosignal am Ausgang des ersten Bandpasses (BP1) mit einem von einem ersten Funktionsgenerator (F1) erzeugten Korrekturfaktor GC multipliziert, einem Verstärker (AM) mit variabler Verstärkung, einem ersten nichtlinearen Schaltkreis (NL1), der die Amplitude des vom Verstärker (AM) um einen Verstärkungsfaktor G verstärkten Audiosignals auf einen vorgebbaren Höchstwert begrenzt, sowie einem zweiten Bandpaß (BP2) aufgebaut ist, dem zweiten Eingang des ersten Addierers (A1) zugeführt wird, daß ein Steuerausgang des ersten nichtlinearen Schaltkreises (NL1) mit dem Eingang des ersten Funktionsgenerators (F1) verbunden ist, dessen Ausgang mit dem ersten Multiplizierer (M1) verbunden ist, daß am Steuereingang des Verstärkers (AM) der Verstärkungsfaktor G anliegt und daß der Korrekturfaktor GC bei Überschreiten des vorgebbaren Höchstwertes verkleinert wird, ansonsten jedoch gleichgehalten oder erhöht wird.

10. Schaltungsanordnung nach Anspruch 9,
**dadurch gekennzeichnet,**
**daß** der erste Funktionsgenerator (F1) als ein erster Tiefpaß (TP1) ausgeführt ist.

11. Schaltungsanordnung nach Anspruch 9 oder 10,
**dadurch gekennzeichnet,**
**daß** der erste nichtlineare Schaltkreis (NL1) aus einem zweiten nichtlinearen Schaltkreis (NL2) und einem zweiten Funktionsgenerator (F2) aufgebaut ist, daß das Eingangssignal des ersten nichtlinearen Schaltkreises (NL1) am Eingang des zweiten nichtlinearen Schaltkreises (NL2) und am Eingang des zweiten Funktionsgenerators (F2) liegt, dessen Ausgang mit dem Steuereingang des zweiten nichtlinearen Schaltkreises (NL2) verbunden ist, daß der Steuerausgang des zweiten nichtlinearen Schaltkreises (NL2) mit dem ersten Funktionsgenerator (F1) oder dem ersten Tiefpaß (TP1) verbunden ist und daß der Signalausgang des zweiten nichtlinearen Schaltkreises (NL2) mit dem Eingang des zweiten Bandpasses (BP2) verbunden ist.

12. Schaltungsanordnung nach Anspruch 11,
**dadurch gekennzeichnet,**
**daß** der zweite Funktionsgenerator (F2) aus einem Spitzenwertdetektor (PK), aus einem zweiten und einem dritten Tiefpaß (TP2, TP3), einem ersten Begrenzer (LIM1) sowie einem Subtrahierer (S) aufgebaut ist, daß der zweite nichtlineare Schaltkreis (NL2) aus einem Absolutwertbildner (ABS), einem zweiten Multiplizierer (M2), einem zweiten Addierer (A2) sowie einem zweiten Begrenzer (LIM2) aufgebaut ist, daß das Eingangssignal des ersten nichtlinearen Schaltkreises (NL1) am ersten Eingang des zweiten Addierers (A2), am Eingang des Absolutwertbildners (ABS) und am Eingang des Spitzenwertdetektors (PK) liegt, dessen Ausgang mit dem Eingang des zweiten Tiefpasses (TP2) und dem Eingang des dritten Tiefpasses (TP3) verbunden ist, daß der Ausgang des zweiten Tiefpasses (TP2) mit dem ersten Eingang und der Ausgang des dritten Tiefpasses (TP3) mit dem zweiten Eingang eines Subtrahierers (S) verbunden ist, dessen Ausgang über den ersten Begrenzer (LIM1) mit dem ersten Eingang des zweiten Multiplizierers (M2) verbunden ist, daß der Ausgang des Absolutwertbildners (ABS) mit dem zweiten Eingang des zweiten Multiplizierers (M2) verbunden ist, dessen Ausgang mit dem zweiten Eingang des zweiten Addierers (A2) verbunden ist, daß der Ausgang des zweiten Addierers (A2) mit dem Eingang des zweiten Begrenzers (LIM2) verbunden ist, dessen Steuerausgang mit dem ersten Funktionsgenerator (F1) oder dem ersten Tiefpaß (TP1) und dessen Ausgang mit dem Eingang des zweiten Bandpasses (BP2) verbunden ist.

## Claims

1. A method for processing an audio signal (Xin), which is supplied via a first path (P1) to the first input of a first adder (A1),
**characterised in that** the audio signal (Xin) is band-limited in a second path (P2) by means of a first bandpass filter (BP1),
**in that** the band-limited audio signal is multiplied at the output of the first bandpass filter (BP1) by a correction factor (GC), is amplified with an amplification factor G and then its amplitude is limited by means of a first non-linear circuit (NL1) to a predetermined maximum value ,
**in that** the correction factor GC is reduced when the predetermined maximum value is exceeded, otherwise in contrast remains constant or is increased,
**in that** the audio signal at the output of the first non-linear circuit (NL1) is band-limited by means of a second bandpass filter (BP2)
**and in that** the band-limited audio signal at the output of the second bandpass filter (BP2) is added to the audio signal of the first path (P1) in the first adder (AD).

2. A method according to Claim 1,
**characterised in that** the correction factor GC is a function F1 of a control variable V which is produced by the first non-linear circuit (NL1).

3. A method according to Claim 2,
**characterised in that** the correction factor (GC) assumes a first value (V1) when the amplitude lies beneath the predetermined threshold value and assumes a second value (V2) when the amplitude is greater than the predetermined threshold value.

4. A method according to Claim 2 or 3,
**characterised in that** the function F1 is realised by means of a first lowpass filter (TP1).

5. A method according to one of Claims 1 to 4,
**characterised in that** the first non-linear circuit (NL1) generates harmonic waves of the low-frequency signal components and weights them with a variable factor NG.

6. A method according to Claim 5,
**characterised in that** the variable factor NG is a function F2 of the input signal of the first non-linear circuit (NL1).

7. A method according to Claim 6,
**characterised in that** the first non-linear circuit (NL1) generates harmonic waves in amplified form at the beginning of a low-frequency signal.

8. A method according to Claim 7,
**characterised in that** in the first non-linear circuit (NL1) according to function F2 the input signal of the first non-linear circuit (NL1) is detected by a peak detector (PK), the output signal of which is lowpass-filtered in a second and a third lowpass filter (TP2, TP3) with different time constants
**and in that the** difference signal of the two lowpass-filtered signals represents the variable factor NG,
**in that** the absolute value of the input signal of the first non-linear circuit (NL1) is weighted with this factor NG and is added to the input signal of the first non-linear circuit (NL1) to form a cumulative value, the amplitude of which is limited to a predetermined value.

9. A circuit configuration for processing an audio signal (Xin), which is fed via a first path (P1) to the first input of a first adder (A1), at the output of which the output signal (Xout) can be removed,
**characterised in that** the audio signal (Xin) is fed to the second input of the first adder (A1) via a second path (P2), which is constructed as a series circuit consisting of a first bandpass filter (BP1), a first multiplier (M1), which multiplies the band-limited audio signal at the output of the first bandpass filter (BP1) with a correction factor GB generated by a first function generator (F1), an amplifier (AM) with variable amplification, a first non-linear circuit (NL1), which limits the amplitude of the audio signal amplified by the amplifier (AM) by an amplification factor G, as well as a second bandpass filter (BP2),
**in that** a control output of the first non-linear circuit (NL1) is connected to the input of the first function generator (F1), the output of which is connected to the first multiplier (M1),
**in that** the amplification factor G lies at the control input of the amplifier (AM)
**and in that** the correction factor GC is reduced if the predetermined maximum value is exceeded, however otherwise it is kept the same or increased.

10. A circuit configuration according to Claim 9,
**characterised in that** the first function generator (F1) is designed as a first lowpass filter (TP1).

11. A circuit configuration according to Claim 9 or 10,
**characterised in that** the first non-linear circuit (NL1) is constructed from a second non-linear circuit (NL2) and a second function generator (F2),
**in that** the input signal of the first non-linear circuit (NL1) lies at the input of the second non-linear circuit (NL2) and at the input of the second function generator (F2), the output of which is connected to the control input of the second non-linear circuit (NL2),
**in that** the control output of the second non-linear circuit (NL2) is connected to the first function generator (F1) or the first lowpass filter (TP1)
**and in that** the signal output of the second non-linear circuit (NL2) is connected to the input of the second bandpass filter (BP2).

12. A circuit configuration according to Claim 11,
**characterised in that** the second function generator (F2) is constructed from a peak detector (PK), a second and a third lowpass filter (TP2, TP3), a first limiter (LIM1) and also a subtractor circuit (S),
**in that** the second non-linear circuit (NL2) is constructed from a device forming absolute values (ABS), a second multiplier (M2), a second adder (A2) as well as a second limiter (LIM2),
**in that** the input signal of the first non-linear circuit (NL1) lies at the first input of the second adder (A2), at the input of the device forming absolute values (ABS) and at the input of the peak detector (PK), the output of which is connected to the input of the second lowpass filter (TP2) and the input of the third lowpass filter (TP3),
**in that** the output of the second low-pass filter (TP2) is connected to the first input and the output of the third lowpass filter (TP3) is connected to the second input of a subtractor circuit (S), the output of which is connected to the first input of the second multiplier (M2) via the first limiter (LIM1),
**in that** the output of the device forming absolute values (ABS) is connected to the second input of the second multiplier (M2), the output of which is connected to the second input of the second adder (A2),
**in that** the output of the second adder (A2) is connected to the input of the second limiter (LIM2), the control output of which is connected to the first function generator (F1) or the first lowpass filter (TP1) and the output of which is connected to the input of the second bandpass filter (BP2).

## Revendications

1. Procédé pour traiter un signal audio (Xin) qui est amené à la première entrée d'un premier circuit d'addition (A1) par un premier chemin (P1),
**caractérisé en ce qu'**
on limite en bande le signal audio (Xin) dans un deuxième chemin (P2) au moyen d'un premier filtre passe-bande (BP1), on multiplie le signal audio à bande limitée par un facteur de correction (GC) à la sortie du premier filtre passe-bande (BP1), on l'amplifie par un facteur de gain G, puis son amplitude est limitée sur une valeur maximale qui peut être prédéfinie au moyen d'un premier circuit non linéaire (NL1), le facteur de correction GC diminue lorsque la valeur maximale prédéfinisable est dépassée, sinon reste constant ou augmente, on limite le signal audio en bande à la sortie du premier circuit non linéaire (NL1) au moyen d'un deuxième filtre passe-bande (BP2), et on ajoute le signal audio à bande limitée à la sortie du deuxième filtre passe-bande (BP2) au signal audio du premier chemin (P1) dans le circuit d'addition (AD).

2. Procédé selon la revendication 1,
**caractérisé en ce que**
le facteur de correction GC est une fonction F1 d'une variable de commande V que le premier circuit non linaire (NL1) produit.

3. Procédé selon la revendication 2,
**caractérisé en ce que**
le facteur de correction (GC) prend une première valeur (V1) lorsque l'amplitude est inférieure à un seuil qui peut être prédéfini, et prend une deuxième valeur (V2) lorsque l'amplitude est supérieure au seuil prédéfinissable.

4. Procédé selon la revendication 2 ou 3,
**caractérisé en ce que**
la fonction F1 est réalisée au moyen d'un premier filtre passe-bas (TP1).

5. Procédé selon l'une des revendications 1 à 4,
**caractérisé en ce que**
le premier circuit non linéaire (NL1) produit des ondes harmoniques des parties de signal à basse fréquence et pondère avec un facteur variable NG.

6. Procédé selon la revendication 5,
**caractérisé en ce que**
le facteur variable NG est une fonction F2 du signal d'entrée du premier circuit non linéaire (NL1).

7. Procédé selon la revendication 6,
**caractérisé en ce que**
le premier circuit non linéaire (NL1) produit des ondes harmoniques amplifiées au début d'un signal à basse fréquence.

8. Procédé selon la revendication 7,
**caractérisé en ce que**
dans le premier circuit non linéaire (NL1), on détecte le signal d'entrée du premier circuit non linéaire (NL1) suivant la fonction F2, par un détecteur de crêtes (PK), dont le signal de sortie est filtré avec des constantes de temps différentes dans un deuxième et un troisième filtre passe-bas (TP2, TP3) et le signal de différence des deux signaux des filtres passe-bas représente le facteur variable NG, on pondère la valeur absolue du signal d'entrée du premier circuit non linéaire (NL1) avec ce facteur NG et on l'ajoute, par rapport au signal d'entrée du premier circuit non linéaire (NL1) à une valeur somme dont l'amplitude est limitée sur une valeur qui peut être prédéfinie.

9. Ensemble de circuits pour traiter un signal audio (Xin) qui est amené par un premier chemin (P1) à la première entrée d'un premier circuit d'addition (A1), à la sortie duquel le signal de sortie (Xout) peut être diminué.
**caractérisé en ce que**
le signal audio (Xin) est amené à la deuxième entrée du premier circuit d'addition (A1), par un deuxième chemin (P2) construit sous la forme d'un montage en série composé d'un premier filtre passe-bande (BP1), d'un premier circuit de multiplication (M1), qui multiplie le signal audio à bande limitée à la sortie du premier filtre passe-bande (BP1) par un facteur de correction GC produit par un premier générateur de fonctions (F1), d'un amplificateur (AM) à amplification variable, d'un premier circuit non linéaire (NL1), qui limite l'amplitude du signal audio amplifié par l'amplificateur (AM) suivant un facteur de gain G sur une valeur maximale qui peut être définie, ainsi que d'un deuxième filtre passe-bande (BP2), une sortie de commande du premier circuit non linéaire (NL1) étant reliée à l'entrée du premier générateur de fonctions (F1) dont la sortie est reliée au premier circuit de multiplication (M1), le facteur de gain G est situé à l'entrée de commande de l'amplificateur (AM), et le facteur de correction GC est diminué lorsque la valeur maximale prédéfinissable est dépassée, sinon reste constant ou augmente.

10. Ensemble de circuits selon la revendication 9,
**caractérisé en ce que**
le premier générateur de fonctions (F1) est réalisé sous la forme d'un premier filtre passe-bas (TP1).

11. Ensemble de circuits selon la revendication 9 ou 10,
**caractérisé en ce que**
le premier circuit non linéaire (NL1) se compose d'un deuxième circuit non linéaire (NL2) et d'un deuxième générateur de fonctions (F2), le signal d'entrée du premier circuit non linéaire (NL1) étant situé à l'entrée du deuxième circuit non linéaire (NL2) et à l'entrée du deuxième générateur de fonctions (F2) dont la sortie est reliée à l'entrée de commande du deuxième circuit non linéaire (NL2), la sortie de commande du deuxième circuit non linéaire (NL2) est reliée au premier générateur de fonctions (F1) ou au premier filtre passe-bas (TP1), et la sortie de signal du deuxième circuit non linéaire (NL2) est reliée à l'entrée du deuxième filtre passe-bande (BP2).

12. Ensemble de circuits selon la revendication 11,
**caractérisé en ce que**
le deuxième générateur de fonctions (F2) se compose d'un détecteur de crêtes (PK), d'un deuxième et troisième filtre passe-bas (TP2, TP3), d'un premier circuit de limitation (LIM1) ainsi que d'un circuit de soustraction (S), et le deuxième circuit non linéaire (NL2) se compose d'un circuit de formation de valeurs absolues (ABS), d'un deuxième circuit de multiplication (M2), d'un deuxième circuit d'addition (A2) ainsi que d'un deuxième circuit de limitation (LIM2), le signal d'entrée du premier circuit non linéaire (NL1) étant situé à la première entrée du deuxième circuit d'addition (A2), à l'entrée du circuit de formation de valeurs absolues (ABS) et à l'entrée du détecteur de crêtes (PK), dont la sortie est reliée à l'entrée du deuxième filtre passe-bas (TP2) et à l'entrée du troisième filtre passe-bas (TP3), la sortie du deuxième filtre passe-bas (TP2) est reliée à la première entrée et la sortie du troisième filtre passe-bas (TP3) est reliée à la deuxième entrée d'un circuit de soustraction (S), dont la sortie est reliée à la première entrée du deuxième circuit de multiplication (M2) par le premier circuit de limitation (LIM1), la sortie du circuit de formation de valeurs absolues (ABS) étant reliée à la deuxième entrée du deuxième circuit de multiplication (M2), dont la sortie est reliée à la deuxième entrée du deuxième circuit d'addition (A2), et la sortie du deuxième circuit d'addition (A2) est reliée à l'entrée du deuxième circuit de limitation (LIM2), dont la sortie de commande est reliée au premier générateur de fonctions (F1) ou au premier filtre passe-bas (TP1), et dont la sortie est reliée à l'entrée du deuxième filtre passe-bande (BP2).
